# EUROPEAN PATENT APPLICATION

(11) **EP 4 340 047 A1**
(43) Date of publication of application: **20.03.2024**
(21) Application number: 22807676.6
(22) Date of filing: 28.04.2022
(51) Int. Cl.: H01L 31/032, C23C 16/30, C23C 16/56, H01L 21/02

(54) **METHOD FOR MANUFACTURING CIGS LIGHT ABSORPTION LAYER FOR SOLAR CELL THROUGH CHEMICAL VAPOR DEPOSITION**

(30) Priority: 11.05.2021 KR 20210060607
(71) Applicant: MECAROENERGY CO. LTD., Chungcheongbuk-do 27915 (KR)
(72) Inventor: KWON, Hea Yong, Jeungpyeong-gun, Chungcheongbuk-do 27918 (KR); JANG, Hyuk Kyoo, Seongnam-si, Gyeonggi-do 13626 (KR); LEE, Gyu Hyun, Chungju-si, Chungcheongbuk-do 27480 (KR); JEON, Tae Yeop, Eumseong-gun, Chungcheongbuk-do 27721 (KR); LEE, Seung Hyun, Jeungpyeong-gun, Chungcheongbuk-do 27920 (KR); EOM, Tae Woo, Jincheon-gun, Chungcheongbuk-do 27872 (KR)
(74) Representative: Lichti - Patentanwälte Partnerschaft mbB
(86) International application number: PCT/KR2022/006130
(87) International publication number: WO 2022/240028

(57) **Abstract**

The present invention relates to manufacturing method of a CIGS light absorption layer for solar cell using chemical vapor deposition, consisting of: a lower electrode forming step of forming a lower electrode on an upper surface of a substrate; a copper thin film forming step of forming a copper thin film with a copper precursor on an upper surface of a lower electrode formed through the lower electrode forming step; an indium thin film forming step of forming an indium thin film with an indium precursor on an upper surface of a copper thin film layer formed through the copper thin film forming step; a gallium thin film forming step of forming a gallium thin film with a gallium precursor on an upper surface of an indium thin film layer formed through the indium thin film forming step; and a heat treatment step of heat-treating in selenium atmosphere a laminate on which a gallium thin film layer is formed through the gallium thin film forming step, wherein the indium thin film forming step and the gallium thin film forming step may be conducted by changing their mutual order. A CIGS light absorption layer for solar cell manufactured through the process described above exhibits a high energy conversion efficiency by effectively controlling a MoSeₓ layer.

## Description

### TECHNICAL FIELD

The present invention relates to a manufacturing method of a CIGS light absorption layer for solar cell using chemical vapor deposition. More specifically, it relates to a manufacturing method of a CIGS light absorption layer for solar cell using chemical vapor deposition that effectively controls a MoSeₓ layer and thereby exhibits a high energy conversion efficiency.

### BACKGROUND ART

To reduce carbon emissions in accordance with environmental regulations, solar cells, which convert sunlight into electrical energy, have few restrictions on installation location, and are capable of easily generating power, are recently attracting attention.

These solar cells are manufactured by using single crystal or polycrystalline silicon wafers, but single crystal silicon generally has the highest photovoltaic efficiency and thus is widely used in large-scale power generation systems and others. However, this single crystal silicon has the disadvantage that the manufacturing process is complicated and the price of cells or modules varies greatly depending on silicon price trend.

Accordingly, as a thin film solar cell to overcome this problem, a method of using a compound semiconductor such as a chalcogenide-based compound has been developed.

Among these, solar cells using Cu (In₁₋ₓGaₓ)Se₂ (hereinafter referred to as CIGS), a chalcogenide-based compound, as a CIGS light absorption layer are evaluated as high-efficiency and low-cost candidates. The CIGS is manufactured by chemical vapor deposition (CVD), and CIGS-applied thin film solar cells manufactured by the chemical vapor deposition described above have advantages for mass production because they have low raw material consumption and are easy to implement large areas, and the devices are relatively simple.

The conventional process of manufacturing CIGS thin film solar cells using chemical vapor deposition involved simultaneously supplying into a reaction chamber four types of precursors, including copper (Cu), indium (In), gallium (Ga), and selenium (Se), on a molybdenum (Mo) thin film, which is a back electrode, to manufacture a CIGS light absorption layer. However, the method described above has a problem that a selenium precursor comes into a direct contact with molybdenum, which is a back electrode, to form an excessively thick MoSeₓ layer on a molybdenum thin film, resulting in a decrease of the efficiency of solar cells.

To solve the problem described above, a method of sequentially supplying copper, gallium, and indium + selenium precursors into a reaction chamber on a molybdenum thin film, which is a back electrode, to form a CIGS light absorption layer or a method of sequentially supplying copper, gallium + selenium, and indium + selenium thin films onto a molybdenum thin film to form a CIGS thin film has been used, and since the method may suppress the formation of a MoSeₓ layer, a high energy conversion efficiency could also be obtained.

However, the method described above had a problem that a thick MoSeₓ layer was formed during a heat treatment process that is conducted to improve efficiency after depositing a CIGS thin film.

### DETAILED DESCRIPTION OF THE INVENTION

### TECHNICAL PROBLEM:

The object of the present invention is to provide a manufacturing method of a CIGS light absorption layer for solar cell using chemical vapor deposition for providing a CIGS light absorption layer that effectively controls a MoSeₓ layer and thereby exhibits a high energy conversion efficiency.

### TECHNICAL SOLUTION:

An object of the present invention is achieved by providing a manufacturing method of a CIGS light absorption layer for solar cell using chemical vapor deposition, consisting of: a lower electrode forming step of forming a lower electrode on an upper surface of a substrate; a copper thin film forming step of forming a copper thin film with a copper precursor on an upper surface of a lower electrode formed through the lower electrode forming step; an indium thin film forming step of forming an indium thin film with an indium precursor on an upper surface of a copper thin film layer formed through the copper thin film forming step; a gallium thin film forming step of forming a gallium thin film with a gallium precursor on an upper surface of an indium thin film layer formed through the indium thin film forming step; and a heat treatment step of heat-treating in selenium atmosphere a laminate on which a gallium thin film layer is formed through the gallium thin film forming step.

An object of the present invention may also be achieved by providing a manufacturing method of a CIGS light absorption layer for solar cell using chemical vapor deposition, consisting of: a lower electrode forming step of forming a lower electrode on an upper surface of a substrate; a copper thin film forming step of forming a copper thin film with a copper precursor on an upper surface of a lower electrode formed through the lower electrode forming step; a gallium thin film forming step of forming a gallium thin film with an indium precursor on an upper surface of a copper thin film layer formed through the copper thin film forming step; an indium thin film forming step of forming an indium thin film with an indium precursor on an upper surface of a gallium thin film layer formed through the gallium thin film forming step; and a heat treatment step of heat-treating in selenium atmosphere a laminate on which an indium thin film layer is formed through the indium thin film forming step.

According to a preferred feature of the present invention, the copper precursor consists of one or more selected from the group consisting of bis(acetylacetonato)copper, bis(2,2,6,6-tetramethylheptanedionato)copper, bis(hexa-fluoroacetylacetonato)copper, (vinyl trimethylsilyl)(hexa-fluoroacetylacetonate)copper, (vinyl trimethylsilyl)(acetylacetonato)copper, (vinyl trimethylsilyl)(2,2,6,6-tetramethylheptandionato)copper, (vinyl triethylsilyl)(acetylacetonato)copper, (vinyl triethylsilyl)(2,2,6,6-tetramethylheptandionato)copper, and (vinyl triethylsilyl)(hexafluoroacetylacetonate)copper.

According to a more preferred feature of the present invention, the indium precursor consists of one or more selected from the group consisting of trimethylindium, triethylindium, triisopropylindium, tributylindium, tri-tert-ibutylindium, trimethoxyindium, triethoxyindium, triisopropoxyindium, dimethyl isopropoxy indium, diethyl isopropoxy indium, dimethyl ethyl indium, diethyl methyl indium, dimethyl isopropyl indium, diethyl isopropyl indium, and dimethyl tert-butyl indium.

According to a more preferred feature of the present invention, the gallium precursor consists of one or more selected from the group consisting of trimethylgallium, triethylgallium, triisopropylgallium, tributylgallium, tri-tert-ibutylgallium, trimethoxygallium, triethoxygallium, triisopropoxygallium, dimethyl isopropoxy gallium, diethyl isopropoxy gallium, dimethyl ethyl gallium, diethyl methyl gallium, dimethyl isopropyl gallium, diethyl isopropyl gallium, and dimethyl *tert-* butyl gallium.

According to an even more preferred feature of the present invention, the copper precursor, the indium precursor, and the gallium precursor are supplied under conditions where the temperature of a canister is -40 to 100°C and the temperature of a supply line is room temperature to 200°C.

According to an even more preferred feature of the present invention, the copper thin film, the indium thin film, and the gallium thin film are formed in a state in which a substrate temperature is from 100 to 500°C.

According to an even more preferred feature of the present invention, the copper thin film, the indium thin film, and the gallium thin film are formed at a pressure of 5 mTorr to 500 Torr.

According to an even more preferred feature of the present invention, the selenium atmosphere is formed by vaporizing a selenium precursor or metal selenium.

According to an even more preferred feature of the present invention, the selenium precursor consists of one or more selected from the group consisting of dimethyl selenide, diethyl selenide, diisopropyl selenide, di-tert-butyl selenide, dimethyl diselenide, diethyl diselenide, diisopropyl diselenide, di-tert-butyl diselenide, tert-butyl isopropyl selenide, and tert-butyl selenol.

According to an even more preferred feature of the present invention, the vaporized selenium precursor or the vaporized metal selenium is supplied through a carrier gas consisting of one or more selected from the group consisting of argon, helium, and nitrogen.

According to an even more preferred feature of the present invention, the heat treatment step is performed at a temperature of 300 to 650°C.

### ADVANTAGEOUS EFFECTS:

The manufacturing method of a CIGS light absorption layer for solar cell using chemical vapor deposition according to the present invention exhibits an excellent effect of providing a CIGS light absorption layer showing a high energy conversion efficiency by effectively controlling a MoSeₓ layer.

### DESCRIPTION OF THE DRAWINGS:

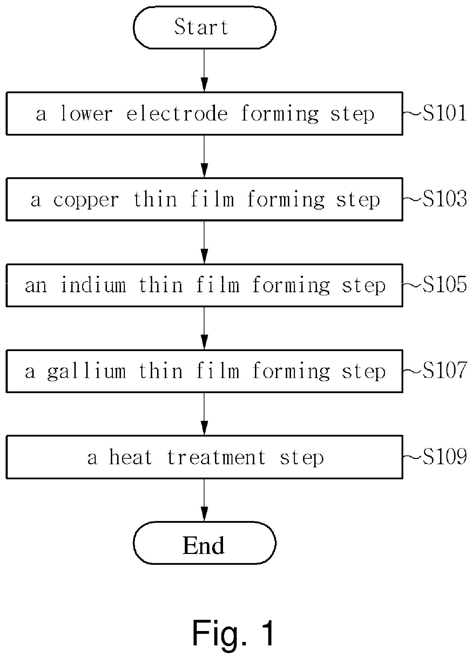

FIG. 1 is a flowchart showing a manufacturing method of a CIGS light absorption layer for solar cell using chemical vapor deposition according to the present invention.

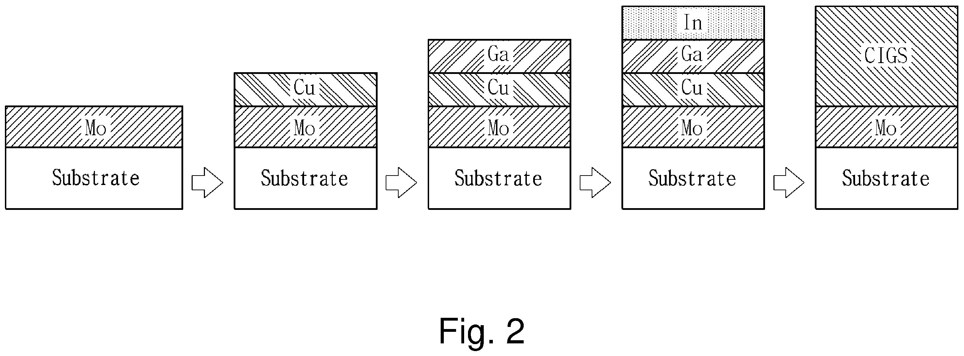

FIG. 2 is a schematic diagram showing a manufacturing process of a CIGS light absorption layer for solar cell using chemical vapor deposition according to one embodiment of the present invention.

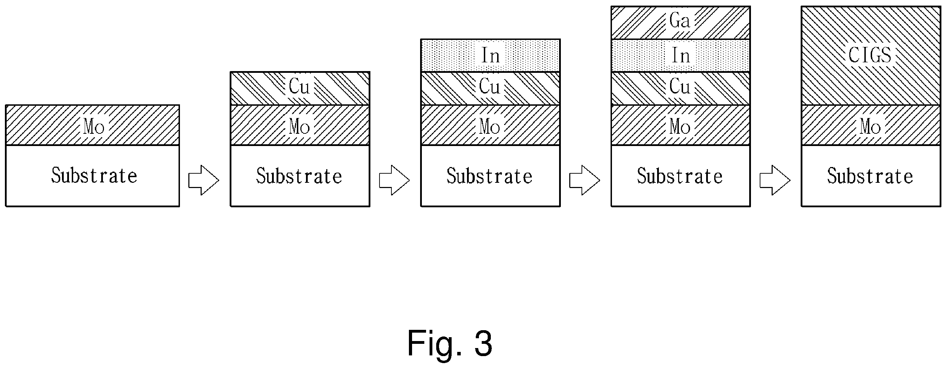

FIG. 3 is a schematic diagram showing a manufacturing process of a CIGS light absorption layer for solar cell using chemical vapor deposition according to one embodiment of the present invention.
FIG. 4 is a photograph showing a CIGS light absorption layer manufactured through Example 1 of the present invention taken with a scanning electron microscope (FE-SEM) .
FIG. 5 is a graph showing the depth profile of a CIGS light absorption layer manufactured through Example 1 of the present invention measured by AES (Auger electron spectroscopy).
FIG. 6 is a graph showing the measured voltage-current characteristics of a CIGS light absorption layer manufactured through Example 1 of the present invention.

### BEST MODE:

Hereinafter, preferred embodiments of the present invention and the physical properties of each component are described in detail, but the description is intended to describe the invention in detail so that those skilled in the art can easily implement the invention. This does not mean that the technical idea and scope of the present invention are limited thereby.

The manufacturing method of a CIGS light absorption layer for solar cell using chemical vapor deposition according to the present invention consists of: a lower electrode forming step (S101) of forming a lower electrode on an upper surface of a substrate; a copper thin film forming step (S103) of forming a copper thin film with a copper precursor on an upper surface of a lower electrode formed through the lower electrode forming step (S101); an indium thin film forming step (S105) of forming an indium thin film with an indium precursor on an upper surface of a copper thin film layer formed through the copper thin film forming step (S103); a gallium thin film forming step (S107) of forming a gallium thin film with a gallium precursor on an upper surface of an indium thin film layer formed through the indium thin film forming step (S105); and a heat treatment step (S109) of heat-treating in selenium atmosphere a laminate on which a gallium thin film layer is formed through the gallium thin film forming step (S107).

The lower electrode forming step (S101) is a step of forming a lower electrode on an upper surface of a substrate, wherein a metal such as molybdenum may be included as a conductive layer, and the thickness of the lower electrode is not particularly limited, but may preferably be 0.1 µm to 1 um, and more preferably 0.4 um to 0.6 um.

In addition, the lower electrode may consist of one layer or may consist of a plurality of layers of two or more layers. When the lower electrode consists of a plurality of layers of two or more layers, individual layers may be formed of the same metal or different metals.

Formation of the lower electrode may be performed by one or more known methods selected from the group consisting of sputtering, co-evaporation, chemical vapor deposition, atomic layer deposition, ion beam deposition, screen printing, spray dip coating, tape casting, and inkjet.

At this time, as the substrate, a glass substrate may be used, and a ceramic substrate, a metal substrate, or a polymer substrate may also be used. For example, as a glass substate, soda lime glass or high strained point soda glass may be used; as a metal substrate, a substrate comprising stainless steel or titanium may be used; and as a polymer substrate, a polyimide substrate may be used. In addition, the substrate may be transparent and may be rigid or flexible.

The copper thin film forming step (S103) is a step of forming a copper thin film with a copper precursor on an upper surface of a lower electrode formed through the lower electrode forming step (S101) and consists of processes of supplying a copper precursor to an upper surface of a lower electrode formed through the lower electrode forming step (S101) and depositing a copper thin film by chemical vapor deposition.

Chemical vapor deposition (CVD) is a step in a semiconductor manufacturing process to form a metal thin film of a metal precursor by using plasma and heat. When chemical vapor deposition is used, there are advantages including high efficiency due to the use of a deposition material, easy expansion into large areas, simple device structure, and possible implementation of a low system price. On the other hand, chemical vapor deposition is used, it is necessary to secure an optimal precursor suitable for a desired process and set optimal conditions in terms of process temperature, pressure, and the like to obtain desired characteristics by using the same. To perform chemical vapor deposition, a chemical vapor deposition device must be provided.

A chemical vapor deposition device preferably comprises a chamber to maintain the interior in a vacuum state; a gate provided on one side of the chamber to carry a substrate into the chamber; a substrate chuck (heating block and susceptor) provided at a lower portion of the chamber to mount the substrate and heat the same to a desired process temperature; and a showerhead provided at an upper portion of the chamber to supply a process gas. In addition, the showerhead may be connected to a plurality of canisters disposed externally to receive a process gas (metal precursor, etc.) supplied from each canister.

The substrate is carried into the inside of chamber through the gate and is fixed to the substrate chuck. After the substrate is carried into the chamber, the gate is sealed, and the inside of the chamber is depressurized. The pressure inside the chamber is preferably 5 mTorr to 500 Torr.

When a copper thin film is deposited by chemical vapor deposition by suppling a copper precursor on the lower electrode, due to deposition of a copper thin film, direct contact between a surface of the lower electrode containing molybdenum and a selenium precursor may be prevented, thereby minimizing the formation of a MoSeₓ layer.

At this time, the canister temperature for supplying the copper precursor is determined in consideration of the vapor pressure of the copper precursor, and the copper precursor is preferably supplied while maintaining the canister temperature at -40°C to 100°C, preferably 25°C to 80°C, and the supply line temperature at room temperature (25°C) to 200°C, but is not limited thereto. When the copper precursor is supplied, the temperature of the substrate is preferably maintained at 100°C to 500°C, and one or more carrier gases selected from the group consisting of argon gas, helium gas, and nitrogen gas are preferably used.

In addition, the deposition thickness of the copper thin film is preferably 100 nm to 200 nm, but is not limited thereto. At this time, when the deposition thickness of the copper thin film is out of the range described above, it becomes difficult to implement an ideal band gap energy of a CIGS light absorption layer.

At this time, the copper precursor preferably consists of one or more selected from the group consisting of bis(acetylacetonato)copper, bis(2,2,6,6-tetramethylheptane-dionato)copper, bis(hexafluoroacetylacetonato)copper, (vinyl trimethylsilyl)(hexafluoroacetylacetonate)copper, (vinyl trimethylsilyl)(acetylacetonato)copper, (vinyl trimethylsilyl)(2,2,6,6-tetramethylheptandionato)copper, (vinyl triethylsilyl)(acetylacetonato)copper, (vinyl triethylsilyl)(2,2,6,6-tetramethylheptandionato)copper, and (vinyl triethylsilyl)(hexafluoroacetylacetonate)copper.

The indium thin film forming step (S105) is a step of forming an indium thin film with an indium precursor on an upper surface of a copper thin film layer formed through the copper thin film forming step (S103) and consists of processes of supplying an indium precursor to an upper surface of a copper thin film layer formed through the copper thin film forming step (S103) and depositing an indium thin film by chemical vapor deposition.

Since the conditions of the chemical vapor deposition, the device used, the thickness of the indium thin film, and others are the same as the conditions for forming a copper thin film in the copper thin film forming step (S103), description about these will be omitted.

At this time, the indium precursor preferably consists of one or more selected from the group consisting of trimethylindium, triethylindium, triisopropylindium, tributylindium, tri-tert-ibutylindium, trimethoxyindium, triethoxyindium, triisopropoxyindium, dimethyl isopropoxy indium, diethyl isopropoxy indium, dimethyl ethyl indium, diethyl methyl indium, dimethyl isopropyl indium, diethyl isopropyl indium, and dimethyl tert-butyl indium.

The gallium thin film forming step (S107) is a step of forming a gallium thin film with a gallium precursor on an upper surface of an indium thin film layer formed through the indium thin film forming step (S105) and consists of processes of supplying a gallium precursor to an upper surface of an indium thin film layer formed through the indium thin film forming step (S105) and depositing a gallium thin film by chemical vapor deposition.

Since the conditions of the chemical vapor deposition, the device used, the thickness of the gallium thin film, and others are the same as the conditions for forming a copper thin film in the copper thin film forming step (S103), description about these will be omitted.

At this time, the gallium precursor preferably consists of one or more selected from the group consisting of trimethylgallium, triethylgallium, triisopropylgallium, tributylgallium, tri-tert-ibutylgallium, trimethoxygallium, triethoxygallium, triisopropoxygallium, dimethyl isopropoxy gallium, diethyl isopropoxy gallium, dimethyl ethyl gallium, diethyl methyl gallium, dimethyl isopropyl gallium, diethyl isopropyl gallium, and dimethyl tert-butyl gallium.

In addition, any step of the indium thin film forming step (S105) and the gallium thin film forming step (S107) may be performed first, that is, thin films may be formed in the order of an indium thin film layer and a gallium thin film layer on an upper surface of a copper thin film layer formed through the copper thin film forming step (S103) or thin films may be formed in the order of a gallium thin film layer and an indium thin film layer on an upper surface of a copper thin film layer.

The heat treatment step (S109) is a step of heat-treating in selenium atmosphere a laminate on which a gallium thin film layer is formed through the gallium thin film forming step (S107) and consists of a process of heat-treating a laminate on which a gallium thin film layer is formed, in selenium atmosphere at a temperature of 300 to 650°C for 1 to 50 minutes.

By optimizing the heat treatment temperature and heat treatment time as described above, sufficient heat treatment may be conducted on the copper thin film layer, the gallium thin film layer, and the indium thin film layer so that a CIGS light absorption layer of a bulk state may be manufactured.

The selenium atmosphere is formed by vaporizing a selenium precursor or metal selenium, and the vaporized selenium precursor or the vaporized metal selenium is supplied through a carrier gas consisting of one or more selected from the group consisting of argon, helium, and nitrogen.

At this time, the selenium precursor preferably consists of one or more selected from the group consisting of dimethyl selenide, diethyl selenide, diisopropyl selenide, di-tert-butyl selenide, dimethyl diselenide, diethyl diselenide, diisopropyl diselenide, di-tert-butyl diselenide, tert-butyl isopropyl selenide, and tert-butyl selenol.

After going through the heat treatment step (S109), the molybdenum thin film layer, which is a back electrode, and the selenium precursor may not meet easily, and thus the formation of a thick MoSeₓ layer is suppressed, thereby providing a CIGS light absorption layer with an excellent energy conversion efficiency.

The band gap energy of the CIGS light absorption layer manufactured through the heat treatment step (S109) is preferably 1.2 eV to 1.8 eV, but is not limited thereto. The bandgap energy of 1.2 eV to 1.8 eV may be adjusted by optimizing the composition of copper, gallium, indium, and selenium in the CIGS light absorption layer, and by maintaining the range described above, the open-circuit voltage (V_{oc}) of a solar cell can be significantly increased.

In addition, the porosity of the CIGS light absorption layer may be 0.1% to 10%. At this time, when the porosity of the CIGS light absorption layer is out of the range described above, a current leakage path is generated, and the photovoltaic efficiency of a solar cell is thereby decreased.

The average grain size of the CIGS light absorption layer may be formed to be large. At this time, when the average grain size of the CIGS light absorption layer is formed to be too small, grain boundaries between crystals disrupt the flow of current, thereby reducing the photovoltaic efficiency of a solar cell.

The final thickness of the CIGS light absorption layer is preferably 500 nm to 3000 nm, but is not limited thereto. At this time, when the final thickness of the CIGS light absorption layer is out of the range described above, the photovoltaic efficiency of the solar cell is decreased.

Hereinafter, a manufacturing method of a CIGS light absorption layer for solar cell using chemical vapor deposition according to the present invention and the properties of the CIGS light absorption layer manufactured by the manufacturing method will be described with examples.

### Example 1:

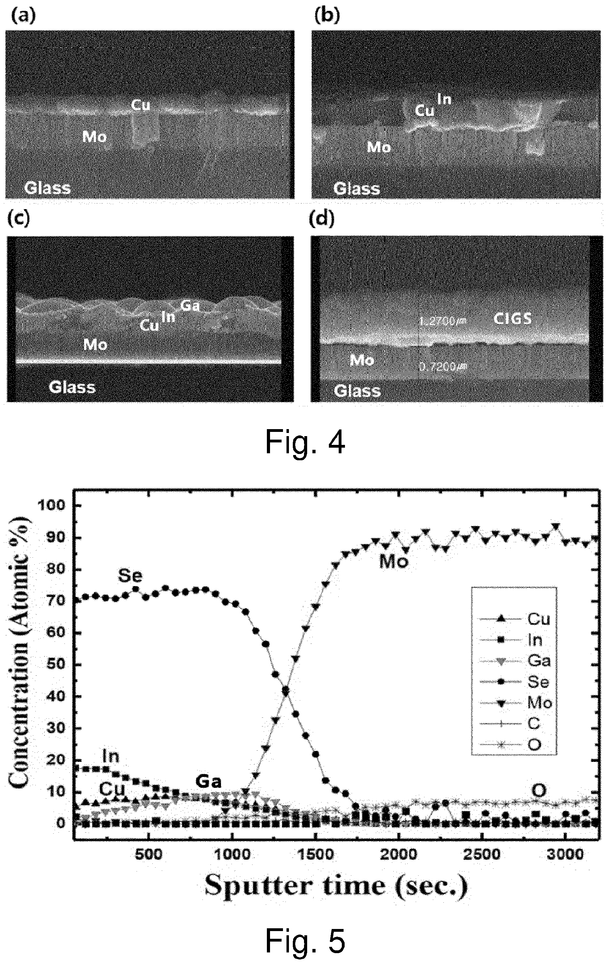

A glass (soda lime glass) substrate was coated with a molybdenum electrode by DC sputtering to form a lower electrode layer in a thickness of about 0.72 um, and a copper precursor {bis(hexafluoroacetylacetonato)copper} was deposited on an upper surface of the lower electrode layer by chemical vapor deposition (canister temperature 40°C, supply line temperature 100°C, substrate temperature 250°C, argon used as a carrier gas) to form a copper thin film layer in a thickness of 0.15 um (FIG. 4A); an indium precursor (trimethyl indium) was deposited on an upper surface of the copper thin film layer by chemical vapor deposition (canister temperature 10°C, supply line temperature 100°C, substrate temperature 250°C, argon used as a carrier gas) to form an indium thin film layer in a thickness of 0.15 um (FIG. 4B); a gallium precursor (triethyl gallium) was deposited on an upper surface of the indium thin film layer by chemical vapor deposition (canister temperature 10°C, supply line temperature 100°C, substrate temperature 250°C, argon used as a carrier gas) to form a gallium thin film layer in a thickness of 0.15 um (FIG. 4C); and a laminate on which the gallium thin film layer was formed was heat-treated in selenium atmosphere (dimethyl selenide vaporized and supplied by using argon gas as a carrier gas) at a temperature of 550°C for 30 minutes to form a CIGS light absorption layer in a thickness of 1.27 um (FIG. 4D).

The depth profile of the CIGS light absorption layer manufactured through Example 1 above was measured by using AES (Auger electron spectroscopy) and is shown in FIG. 5 below.

Specifically, after irradiating an electron beam on a surface of the CIGS light absorption layer, AES (Auger Electron Spectroscopy) was performed by measuring the energy of emitted Auger electrons in real time to analyze the type and content of elements constituting the surface.

As shown in FIG. 5 below, the selenium content was found to be the highest in the surface area of the CIGS light absorption layer manufactured through Example 1, and the deeper the depth, the higher the molybdenum content.

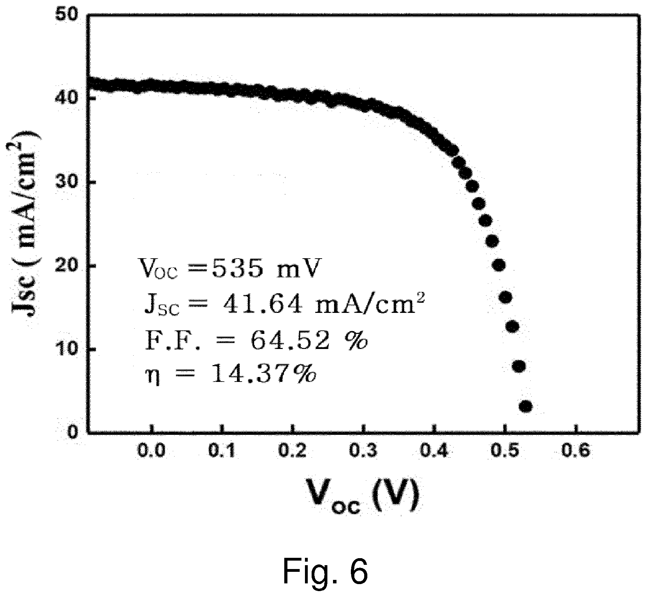

In addition, the voltage-current characteristics of the CIGS light absorption layer manufactured through Example 1 above were measured and are shown in FIG. 6 below.

As shown in FIG. 6 below, the CIGS light absorption layer manufactured through Example 1 of the present invention exhibits an excellent energy conversion efficiency.

Therefore, the manufacturing method of a CIGS light absorption layer for solar cell using chemical vapor deposition according to the present invention provides a CIGS light absorption layer exhibiting a high energy conversion efficiency by effectively controlling a MoSeₓ layer.

In the foregoing, the present invention has been described in detail, focusing on the examples, but it is obvious to those skilled in the art that various changes and modifications are possible within the scope of the technical idea of the present invention, and it is obvious that such changes and modifications fall within the scope of the appended claims.

## Claims

1. A manufacturing method of a CIGS light absorption layer for solar cell using chemical vapor deposition, consisting of: a lower electrode forming step of forming a lower electrode on an upper surface of a substrate; a copper thin film forming step of forming a copper thin film with a copper precursor on an upper surface of a lower electrode formed through the lower electrode forming step; an indium thin film forming step of forming an indium thin film with an indium precursor on an upper surface of a copper thin film layer formed through the copper thin film forming step; a gallium thin film forming step of forming a gallium thin film with a gallium precursor on an upper surface of an indium thin film layer formed through the indium thin film forming step; and a heat treatment step of heat-treating in selenium atmosphere a laminate on which a gallium thin film layer is formed through the gallium thin film forming step.

2. A manufacturing method of a CIGS light absorption layer for solar cell using chemical vapor deposition, consisting of: a lower electrode forming step of forming a lower electrode on an upper surface of a substrate; a copper thin film forming step of forming a copper thin film with a copper precursor on an upper surface of a lower electrode formed through the lower electrode forming step; a gallium thin film forming step of forming a gallium thin film with a gallium precursor on an upper surface of a copper thin film layer formed through the copper thin film forming step; an indium thin film forming step of forming an indium thin film with an indium precursor on an upper surface of a gallium thin film layer formed through the gallium thin film forming step; and a heat treatment step of heat-treating in selenium atmosphere a laminate on which an indium thin film layer is formed through the indium thin film forming step.

3. The manufacturing method of a CIGS light absorption layer for solar cell using chemical vapor deposition according to claim 1 or 2, wherein the copper precursor consists of one or more selected from the group consisting of bis(acetylacetonato)copper, bis(2,2,6,6-tetramethyl-heptanedionato)copper, bis(hexafluoroacetyl-acetonato)copper, (vinyl trimethylsilyl)(hexafluoroacetyl-acetonate)copper, (vinyl trimethylsilyl)(acetyl-acetonato) copper, (vinyl trimethylsilyl)(2,2,6,6-tetra-methylheptandionato)copper, (vinyl triethylsilyl)(acetyl-acetonato)copper, (vinyl triethylsilyl)(2,2,6,6-tetra-methylheptandionato)copper, and (vinyl triethylsilyl)(hexa-fluoroacetylacetonate)copper.

4. The manufacturing method of a CIGS light absorption layer for solar cell using chemical vapor deposition according to claim 1 or 2, wherein the indium precursor consists of one or more selected from the group consisting of trimethylindium, triethylindium, triisopropylindium, tributylindium, tri-tert-ibutylindium, trimethoxyindium, triethoxyindium, triisopropoxyindium, dimethyl isopropoxy indium, diethyl isopropoxy indium, dimethyl ethyl indium, diethyl methyl indium, dimethyl isopropyl indium, diethyl isopropyl indium, and dimethyl tert-butyl indium.

5. The manufacturing method of a CIGS light absorption layer for solar cell using chemical vapor deposition according to claim 1 or 2, wherein the gallium precursor consists of one or more selected from the group consisting of trimethylgallium, triethylgallium, triisopropylgallium, tributylgallium, tri-tert-ibutylgallium, trimethoxygallium, triethoxygallium, triisopropoxygallium, dimethyl isopropoxy gallium, diethyl isopropoxy gallium, dimethyl ethyl gallium, diethyl methyl gallium, dimethyl isopropyl gallium, diethyl isopropyl gallium, and dimethyl tert-butyl gallium.

6. The manufacturing method of a CIGS light absorption layer for solar cell using chemical vapor deposition according to claim 1 or 2, wherein the copper precursor, the indium precursor, and the gallium precursor are supplied under conditions where the temperature of a canister is -40 to 100°C and the temperature of a supply line is room temperature to 200°C.

7. The manufacturing method of a CIGS light absorption layer for solar cell using chemical vapor deposition according to claim 1 or 2, wherein the copper thin film, the indium thin film, and the gallium thin film are formed in a state in which a substrate temperature is from 100 to 500°C.

8. The manufacturing method of a CIGS light absorption layer for solar cell using chemical vapor deposition according to claim 1 or 2, wherein the copper thin film, the indium thin film, and the gallium thin film are formed at a pressure of 5 mTorr to 500 Torr.

9. The manufacturing method of a CIGS light absorption layer for solar cell using chemical vapor deposition according to claim 1 or 2, wherein the selenium atmosphere is formed by vaporizing a selenium precursor or metal selenium.

10. The manufacturing method of a CIGS light absorption layer for solar cell using chemical vapor deposition according to claim 9, wherein the selenium precursor consists of one or more selected from the group consisting of dimethyl selenide, diethyl selenide, diisopropyl selenide, di-tert-butyl selenide, dimethyl diselenide, diethyl diselenide, diisopropyl diselenide, di-tert-butyl diselenide, tert-butyl isopropyl selenide, and tert-butyl selenol.

11. The manufacturing method of a CIGS light absorption layer for solar cell using chemical vapor deposition according to claim 9, wherein the vaporized selenium precursor or the vaporized metal selenium is supplied through a carrier gas consisting of one or more selected from the group consisting of argon, helium, and nitrogen.

12. The manufacturing method of a CIGS light absorption layer for solar cell using chemical vapor deposition according to claim 1 or 2, wherein the heat treatment step is performed at a temperature of 300 to 650°C.
